Europäisches Patentamt

European Patent Office

Office européen des brevets

(11) Publication number: **0 146 207**
A2

## (12) EUROPEAN PATENT APPLICATION

(21) Application number: **84305981.7**

(22) Date of filing: **31.08.84**

(51) Int. Cl.⁴: **H 01 H 9/04**

(30) Priority: **06.12.83 GB 8332514**

(43) Date of publication of application: **26.06.85**
Bulletin 85/26

(84) Designated Contracting States: **AT BE CH DE FR IT LI LU NL SE**

(71) Applicant: **DUBILIER PLC, Dubilier House Radley Road, Abingdon Oxford OX14 3XA (GB)**

(72) Inventor: **James, Kenneth Samuel, 64, Nightingale Avenue, Frome Somerset. BA11 2UW (GB)**

(74) Representative: **Warren, Francis Charles et al, Baron & Warren 18 South End Kensington, London W8 5BU (GB)**

(54) Improvements in electrical components.

(57) A process for the encapsulation of an electrical component (1) provided with at least one movable member (5), such as an overheating protection device, arranged externally of the component. The process comprises the steps of coating the component with a wax like material (2) in a molten state and in a sufficient amount to cover said at least one movable member (5), allowing said wax like material to solidify, incapsulating the wax coated component in an encapsulating material (3) having a solidifying temperature which is lower than the melting point of the wax like material and solidifying the encapsulating material.

# IMPROVEMENTS IN ELECTRICAL COMPONENTS

The present invention relates to electrical components and more particularly to electrical components which are encapsulated (sometimes called "potted") in an outer covering in order to provide environmental protection.

The invention is specifically concerned with the encapsulation of electrical components having one or more external parts which are movable, such as movable contacts, or temperature responsive devices, for example as are described in our copending British application No. 8324174.

It has been found that when it is attempted to encapsulate such electrical components employing known techniques, the encapsulating material may thereafter inhibit the operation of the movable contacts or members thereby preventing the proper operation of such devices, e.g. the proper operation of an overheating protection device.

It is an object of the present invention to provide an improved process for the encapsulation of electrical components in which the aforementioned disadvantage is substantially reduced or avoided.

The present invention provides a process for the encapsulation of an electrical component provided with at least one external movable contact or other member wherein the component is first coated with a wax like material which is allowed to solidify and the resulting wax coated assembly is then encapsulated in the desired encapsulating material. As applied to an electrical component in which the externally movable contacts or members comprise a temperature responsive device such as an overheating protection device, the wax like coating is of a wax which melts at a temperature below the operating temperature of the overheating protection device.

The process according to the present invention may be carried out by immersing the component in a molten wax, for example paraffin wax, withdrawing the component from the molten wax to allow the wax coating thereon to solidify, suspending the wax-coated component in a mould or potting box and pouring an encapsulating material into the mould or potting box to completely cover the assembly, curing or solidifying the encapsulant and removing the encapsulated component from the mould or potting box. Alternatively, the molten wax may be in a temporary mould in which the component is located until the wax has solidified in order to provide a relatively thick wax coating of desired configuration. The temporary mould may be force-cooled to aid solidification of the wax.

It will thus be seen that the encapsulated electrical component comprises the basic component covered with a thick layer or film of solidified wax and completely enclosed within an encapsulant. Since the melting point of the wax is always lower than the operating temperature of the overheating protection device, when the protection device reaches its operating temperature, it will be surrounded by molten wax which offers little or no mechanical resistance to the movements of the elements of the protection device.

Most of·the known commercially available waxes may be employed which are reasonably chemically inert, which are solid at room temperature and which melt at a comparatively low temperature, for example 40° to 70°.

The encapsulant may include most of the epoxy casting resins, silicone resins, polyester resins or polyurethanes, although those producing strong exothermic reactions should be avoided in the case of temperature responsive devices. In such cases the curing temperature of the encapsulant is lower than that of the wax employed.

According to one specific example, an electrical component provided with a temperature responsive device forming an overheating protection device of the type disclosed in our aforementioned copending application 8324174 was encapsulated by initially dipping the component in a bath of paraffin wax having a melting point of about 45°C, and which was held just above this temperature. The overheating protection device had an operating temperature in the region of 175°C which is well above the melting temperature of the wax. The component was then withdrawn from the bath of wax and the wax coating was allowed to solidify. The wax-coated component was then encapsulated in a polyurethane material by placing it into a mould and pouring the polyurethane into the mould to completely cover the assembly. The polyurethane material had a curing temperature of 25 to 30°C. The encapsulated component was then removed from the mould, it being understood that during the coating and encapsulation process, the wire lead-outs or terminals from the component were maintained free of coatings.

One embodiment of an encapsulated component according to the invention is shown in the accompanying drawings in which:-

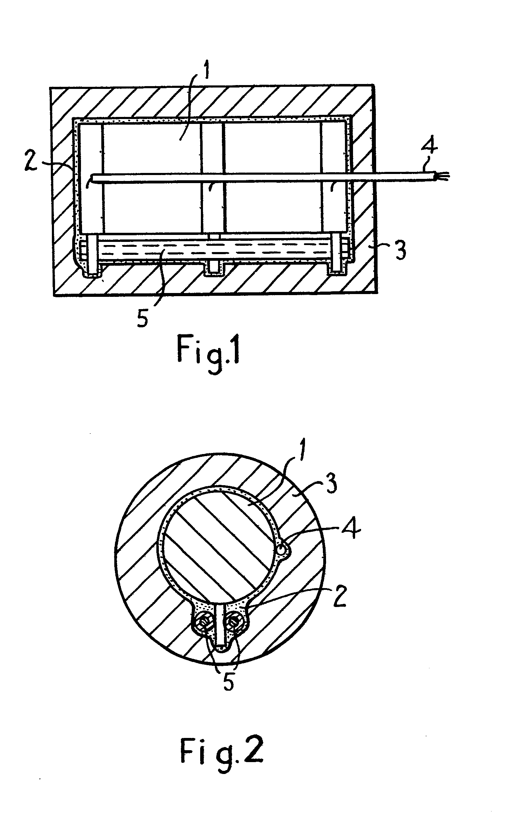

Fig. 1 is a side view partly in section, and

Fig. 2 is a cross-section through the encapsulated component.

The component 1 is a gas discharge tube or surge voltage arrestor incorporating an overheating protection device generally indicated at 5 and of the kind generally disclosed in our aforementioned copending application. The component 1 is surrounded by a relatively thick layer of paraffin wax 2 and the resulting assembly is itself encapsulated in a polyurethane material 3 with the connecting leads 4 to the component projecting free of encapsulation. The melting point of the wax 2 is well below the operating temperature of the overheating protection device, so if the component reaches an overheated temperature at which the device needs to operate, the wax will then have melted or at least softened sufficiently to allow the temperature responsive contacts of the overheating protection device 5 to operate. In other words, the provision of the wax layer 2 prevents the encapsulant from adhering to the overheating protection device contacts such as to prevent it from operating when required. Since the wax when molten offers little or no mechanical resistance to the movements of the overheating protection device, it is free to move when the wax melts.

Whilst a particular embodiment has been described, it will be understood that various modifications may be made without departing from the scope of this invention. Thus it will be obvious that the invention may clearly be applied to other electrical components besides that specifically described and the moving contacts need not be an overheating protection device. Moreover other waxes and encapsulants may be used, providing that the melting point of the selected wax is lower than the operating temperature of the overheating protection device, is compatible with the material of the encapsulant and that curing temperature of the selected encapsulant is lower than the melting point of the wax selected.

CLAIMS

1. A process for the encapsulation of an electrical component provided with at least one movable member arranged externally of the component, characterised in that the process comprises the steps of coating the component (1) with a wax like material (2) in a molten state and in a sufficient amount to cover said at least one movable member (5), allowing said wax like material to solidify, encapsulating the wax coated component in an encapsulating material (3) having a solidifying temperature which is lower than the melting point of the wax like material and solidifying the encapsulating material.

2. A process according to claim 1, characterised in that, at least once, the component is immersed in a molten wax and is then withdrawn from the molten wax to allow the wax coating thereon to solidify.

3. A process as claimed in claim 1, characterised in that the component is coated with wax like material by immersing it in a mould of desired configuration containing the molten wax like material and allowing the wax like material to solidify, whereafter the component coated with wax to the desired configuration is withdrawn from the mould.

4. A process according to claim 1,2 or 3, characterised in that the encapsulation is carried out by suspending the wax coated component in a mould, pouring an encapsulating material into the mould so as completely to cover the wax coated component, solidifying the encapsulant and removing the encapsulated component from the mould.

5. A process according to any preceding claim, characterised in that the wax like material is a commercially available wax which is solid at room temperature and which melts within the range of 40° to 70°C.

6. A process according to any preceding claim, characterised in that the encapsulant is selected from the group of materials comprising epoxy casting resins, silicone resins, polyester resins, and polyurethanes and is such that the curing temperature of the encapsulant is lower than the melting point of the wax employed for the wax like coating.

7. A process according to any preceding claim, characterised in that the at least movable member (5) disposed externally of the electrical component (1) comprises an overheating protection device and wherein the wax like coating is of a wax (2) which melts at a temperature below the operating temperature of said overheating protection device.

8. An encapsulated electrical component comprising at least one member arranged externally of the component, characterised in that a coating of a wax like material (2) enshrouds said at least one movable member (5) and in that an encapsulation (3) encloses the assembly of said component (1) and said coated at least one movable member (5).

9. An encapsulated component as claimed in claim 8, characterised in that said at least one movable member (5) comprises an overheating protection device.

10. An encapuslated component as claimed in claim 9, characterised in that the component (1) comprises a surge voltage arrestor.

1/1

Fig.1

Fig.2